# EUROPEAN PATENT SPECIFICATION

(11) **EP 2 797 228 B1**
(45) Date of publication and mention of the grant of the patent: **20.04.2016**
(21) Application number: 13165491.5
(22) Date of filing: 26.04.2013
(51) Int. Cl.: H03F 3/08, G01J 1/44, G01J 1/46

(54) **METHOD FOR DETECTING A PHOTOCURRENT**
VERFAHREN ZUR ERKENNUNG EINES FOTOSTROMS
PROCÉDÉ POUR DÉTECTER UN COURANT PHOTOÉLECTRIQUE

(43) Date of publication of application: 29.10.2014
(73) Proprietor: Xenics N.V., 3001 Leuven (BE)
(72) Inventor: Van Bogget, Urbain, 3700 Tongeren (BE)
(74) Representative: Van Bladel, Marc

(56) References cited:
- JP-A- 2002 171 142
- US-A- 5 929 434
- US-A1- 2011 068 860

## Description

### Field of the invention

The present invention is generally related to the field of detection circuits, particularly detection circuits for infrared applications.

### Background of the invention

Imagers for the visible wavelengths have been produced in the art with both linear and logarithmic response. A linear response is obtained by simply charging a photosensitive silicon diode stray capacitance while biased in reverse direction. A logarithmic response is achieved by adding a diode connected MOS transistor at the photodiode output node and using the logarithmic characteristic of the so connected transistor to obtain the logarithmic compression. Both types generally use the so called Source Follower per Detector (SFD) method to isolate the weak voltage stored in the photodiode or an additional hold capacitor in order to route it to highly capacitive loaded column nodes.

This relatively simple scheme can be used with visible wavelength silicon based detectors because the leakage of these silicon diodes is still very low even at normal uncooled operating temperatures, and so the change of reverse bias will only marginally affect the signal.

However, in infrared applications, the photodiodes are made with other materials resulting in much higher leakage currents equivalent to a smaller leakage resistor in parallel with the detectors. The simple charging of the diode's parallel capacitor is therefore not practically usable anymore at uncooled operating temperatures. An amplifier is therefore generally used to keep the photodiode reverse voltage constant and as close as possible to the zero bias in order to minimize the effect of the photodiode leakage resistor. The amplifier stabilizing negative feedback element can be a resistor or a capacitor. The resistor feedback is never used in practical pixel arrays as built nowadays, because very large linear resistor values are needed for the pixel to be sensitive. These large resistors are not compatible with the pixel size and the volume CMOS processes generally used. Therefore a small capacitor is generally used to obtain a dynamic operation similar to a shutter in a photo-chemical film camera. The amplifier is therefore generally called Capacitive Trans Impedance Amplifier (CTIA). One particular advantage of a CTIA is that the gain (expressed in Volts/electron) is adjustable by just changing the integration time. In this way the photo-film and shutter speed adjustments are imitated.

A focal plane array comprises several individual detector elements (pixels). The number of pixels in a linear or focal plane array is increasing. The signal multiplexer is a high complexity detector specific integrated circuit, which reads all pixels in series but also often through multiple channels in parallel. In a commonly used detector circuit the above-mentioned capacitive feedback transimpedance amplifier (CTIA) is applied to accumulate the detector current. The amplifier keeps the detector at virtual ground while the detector current is flowing onto the capacitor, generating a voltage signal at the output proportional to the integration time and the signal current.

There are however limitations to the adjustments applied to the CTIA. The dynamic range is in any case limited by the ratio between the largest non-saturating output and the noise level. The response of these CTIA pixel amplifiers is linear and practically not compatible with very high photocurrents requiring a large so-called well capacity and a sufficient supply voltage to avoid saturation.

Patent application US2011/068860 discloses a detection circuit with an improved anti-blooming circuit. The detection circuit comprises a photodiode connected to an input of a capacitive transimpedance amplifier (CTIA). When the photodiode receives too intense light radiation a so-called blooming effect occurs on adjacent photodiodes of the linear or focal plane array. This effect is due to the fact that the voltage difference at the capacitor terminals of the CTIA then becomes so high that the photodiode bias voltage is affected. This bias change leads to a modification of the photon collection surface in the adjacent photodiodes. The blooming effect as such is well known in the art and is typically countered by providing a transistor in parallel to the terminals of the capacitor. The transistor prevents the photodiode from changing bias, while not preventing the capacitor from storing an amount of charges necessary for the lighting of the observed scene. In US2011/068860 the proposed solution comprises between the input and an output of the CTIA an anti-blooming circuit containing a field effect transistor. The transistor is of pMOS type when the CTIA input is connected to a cathode of the photodiode and of nMOS type when the CTIA input is connected to an anode of the photodiode. The anti-blooming circuit comprises means for comparing the voltage on output from the CTIA with a setpoint voltage, whereby the means for comparing is connected to means for applying a feedback current to the CTIA input when the difference between the output voltage and the setpoint voltage reaches a limit value.

Hence, US2011/068860 teaches to define when the transistor is on or off depending on the difference between the setpoint voltage and the amplifier output voltage. If this difference is below a threshold value, the transistor is in the off state and if it is above that threshold it is in the on state. However, the transistor cannot be seen as a merely logical switch that switches on at a particular threshold level Vₜ. The circuit proposed in US2011/068860 therefore yields a performance considerably below the optimum.

Hence, there is a need for a solution where the detection circuit provides an improved performance, wherein properties of the circuit components are better exploited. Further there is a need for a circuit that allows extracting information from pixels susceptible of being affected by blooming.

### Summary of the invention

It is an object of embodiments of the present invention to provide for a detection circuit which is operable in a wider useful detector current range than the above-mentioned prior art solutions.

The above objective is accomplished by the solution according to the present invention.

In a first aspect the invention relates to a method for operating a detection circuit for detecting photocurrent, said detection circuit comprising a photodiode, a pixel amplifier and a MOS transistor having a gate, a source and a drain, said photodiode being connected to an input of a pixel amplifier and said MOS transistor being connected between the input of the pixel amplifier and an output of the pixel amplifier. The method comprises the steps of
- illuminating the photodiode, yielding a photocurrent,
- applying an input voltage to the pixel amplifier, said input voltage derived from the photocurrent,
- applying a current output by the pixel amplifier to the MOS transistor whereby said output current forms a current between the drain and source of the MOS transistor, said MOS transistor being supplied at the gate with a gate voltage, until the current between the drain and source is substantially in balance with the photocurrent,
- exploiting a logarithmic portion of a gate-to-source voltage characteristic as a function of the current between the drain and source of the MOS transistor to obtain at the pixel amplifier output a voltage being a logarithmic function of the photocurrent.

The above-described way of working indeed better exploits the characteristics of the MOS transistor, thereby obtaining an improved performance of the detection circuit. From the photocurrent a voltage signal is derived, e.g. by charging the input node stray capacitances comprising the sum of the detector capacitance, amplifier input capacitance, optionally reset switch capacitance, and the MOS transistor capacitance, which is input to the pixel amplifier. At the amplifier output a current is obtained which is applied to the source of the MOS transistor. The MOS transistor gate is fed with a fixed gate voltage so chosen to avoid the amplifier output reaching the supply rail and so saturating, whereby it would thus lose its transconductance amplification characteristics.

In one embodiment the MOS transistor is a NMOS transistor. In another embodiment, depending on the polarity of the detector current, the MOS transistor is a PMOS transistor.

In a preferred embodiment the pixel amplifier is a capacitive transimpedance amplifier.

In an advantageous embodiment the operation can be continuous requiring no reset. Alternatively, the detection circuit is provided with a reset switch that optionally is also implemented with a MOS transistor.

In a preferred embodiment the method comprises a step of pulsing the gate voltage to a supply rail so that a reset function is achieved.

In an advantageous embodiment the logarithmic portion of the gate-to-source voltage characteristic as a function of the current between the drain and source has a slope of about 60mV/input current decade at room temperature.

In another aspect the invention relates to a method for calibrating a detection circuit for detecting photocurrent, said detection circuit comprising a photodiode, a pixel amplifier and a MOS transistor having a gate, a source and a drain, said photodiode being connected to an input of a pixel amplifier and said MOS transistor being connected between said input of said pixel amplifier and an output of said pixel amplifier, the method comprising the steps of
- selecting a transistor gate voltage level whereby saturation of the output of said pixel amplifier is avoided,
- increasing the level of illumination applied to said photodiode until saturation of the output of said pixel amplifier is reached,
- reducing gradually the level of illumination with a given step, thereby modifying said output of said amplifier, according to a logarithmic characteristic of a gate-to-source voltage as a function of a drain-source current of said MOS transistor, with a substantially constant amount until an output variation is observed substantially higher than said substantially constant amount, whereby levels of illumination corresponding to a modification of said output with said substantially constant amount determine a logarithmic range.

In the proposed calibration method first the illumination level is determined where the pixel amplifier output saturates. Then the level of illumination is gradually reduced, each time with a same percentage. The amplifier output is thereby modified with a more or less constant amount as long as one remains in the logarithmic operating range. Once a substantially higher output variation is observed for a reduced level of illumination, one knows one has reached the linear range, beyond the logarithmic range of operation.

In a further aspect the invention also relates to detection circuit for detecting photocurrent comprising a photodiode, a pixel amplifier and a MOS transistor having a gate, a source and a drain, said photodiode being connected to an input of a pixel amplifier and said MOS transistor being connected between said input of said pixel amplifier and an output of said pixel amplifier, whereby said detection circuit is calibrated with the method for calibrating as previously described.

In one embodiment the detection circuit for detecting photocurrent has a differential implementation.

The invention also relates to an array of pixels comprising a plurality of detection circuits as described.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other objects or advantages as may be taught or suggested herein.

The above and other aspects of the invention will be apparent from and elucidated with reference to the embodiment(s) described hereinafter.

### Brief description of the drawings

The invention will now be described further, by way of example, with reference to the accompanying drawings, wherein like reference numerals refer to like elements in the various figures.
Fig.1 illustrates the logarithmic behaviour of the source voltage (when at the gate 1V is applied) as a function of the current between drain and source of a NMOS transistor.
Fig.2 illustrates an embodiment of the circuit according to the present invention with a NMOS transistor and a photodiode with P diffusion anode connected to the amplifier input.
Fig.3 illustrates an embodiment of the circuit according to the present invention with a PMOS transistor and a photodiode with N diffusion cathode connected to the amplifier input.
Fig.4 illustrates an embodiment of the circuit of the invention with a NMOS transistor and a reset switch and a photodiode with P diffusion anode connected to the amplifier input.
Fig.5 illustrates an embodiment of the circuit of the invention with a PMOS transistor and a reset switch and a photodiode with N diffusion cathode connected to the amplifier input.
Fig.6 illustrates a possible single ended implementation of the inverting amplifier shown in the previous figures.
Fig.7 represents another possible single ended implementation of the inverting amplifier shown in the previous figures.
Fig.8 illustrates a possible differential implementation of the inverting amplifier shown in Figures 2 to 5.
Fig.9 illustrates another possible differential implementation of the inverting amplifier shown in Figures 2 to 5.
Fig.10 illustrates the behaviour of the amplifier output voltage as a function of time, for a number of photocurrent values.

### Detailed description of illustrative embodiments

The present invention will be described with respect to particular embodiments and with reference to certain drawings but the invention is not limited thereto but only by the claims.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

It should be noted that the use of particular terminology when describing certain features or aspects of the invention should not be taken to imply that the terminology is being redefined herein to be restricted to include any specific characteristics of the features or aspects of the invention with which that terminology is associated.

In the description provided herein, numerous specific details are set forth. However, it is understood that embodiments of the invention may be practiced without these specific details. In other instances, well-known methods, structures and techniques have not been shown in detail in order not to obscure an understanding of this description.

Generally speaking, CMOS imagers have to deal with very small currents and therefore they most naturally operate in subthreshold or weak inversion mode. The present invention capitalizes on the logarithmic characteristics displayed by a MOS transistor. This especially holds in the subthreshold area or in weak inversion mode, where the response is constant and close to about 60mV per decade of source and drain current at room temperature.

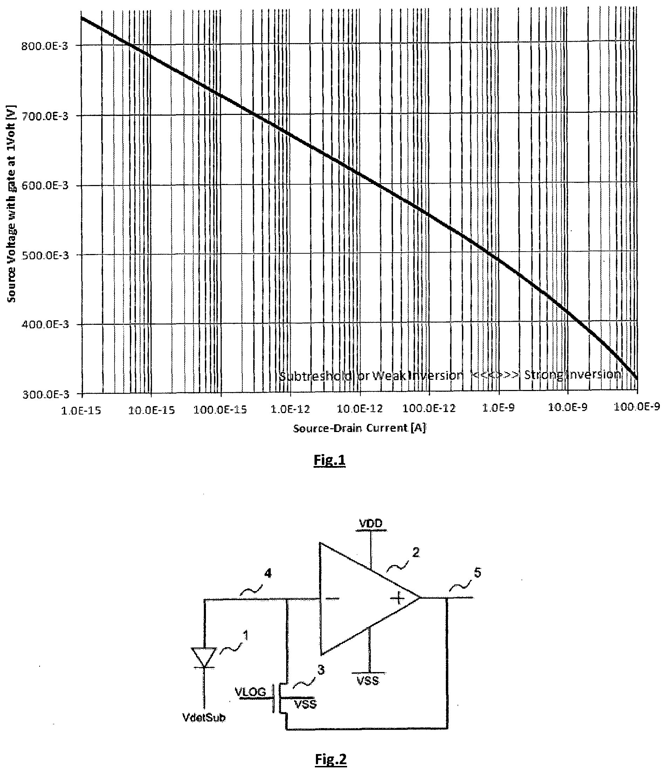

Fig.1 shows the voltage at the source of a NMOS transistor when at its gate a voltage of 1V is applied, as a function of the source-drain current. The latter is represented using a logarithmic scale. Over a large range there is a linear relationship between source voltage and the logarithm of the current between source and drain. This range is referred to as being in subthreshold or weak inversion mode. For higher current values a deviation from the linear relation is noticeable, this is the zone of strong inversion.

Several statements in above-mentioned patent application US2011/068860 make clear it is assumed that the MOS transistor has only two states, Off state below a gate to source threshold voltage Vₜ and On state above the gate to source voltage Vₜ. This means that the logarithmic characteristic of the gate to source voltage in function of source to drain current is not considered at all and the opportunities it offers are indeed not exploited. Patent application US2011/068860 also completely neglects an important requirement for correct operation, namely that the current bias of the amplifier must be sufficiently high as compared to the highest expected photocurrent.

In the present invention the pixel amplifier uses the exponential drain source current in function of gate voltage or the logarithmic gate to source voltage in function of the drain and source current characteristic of a CMOS transistor which is connected as the negative feedback and usually operated in weak inversion. The gate is biased at a potential so chosen that amplifier output saturation is avoided. The source is connected to the amplifier output and the drain to the inverting input.

Subthreshold or weak inversion operation is not an absolute requirement for the present invention to be usable. It should be noted however that in the strong inversion region that is possibly reached in the very rare cases where the pixel bias would be set at very high values for accepting extremely high photocurrents, subsequent data manipulation that may possibly be needed, is much more complex because of the less predictable behaviour of the detection circuit.

When the photodiode anode is connected at the amplifier input, the feedback transistor must be of NMOS type. In this case the photocurrent flowing into the amplifier's inverting input forces the amplifier output voltage to decrease until the feedback NMOS gate to source voltage reaches (after a short stabilization time) a value whereby the current flowing from drain to source equals the photocurrent. At that point the amplifier does not supply any current anymore to the output node. The amplifier output drops about 60mV when the photocurrent increases over a decade at room temperature.

In case the photodiode cathode is connected to the amplifier input, the feedback transistor must be of PMOS type. The photocurrent flowing out of the amplifiers inverting input then forces the amplifier output voltage to rise until the feedback PMOS gate to source voltage reaches (after a short stabilization time) a value whereby the current flowing from drain to source equals the photocurrent. The amplifier is kept in balance. The amplifier output will change about 60mV/decade increase of the photocurrent at room temperature. The amplifier input voltage change in function of photocurrent is significantly reduced by the open loop voltage gain of the amplifier. The incoming photocurrent is limited by the value of the bias current of the amplifier because the amplifier has at least to be able to drain the photocurrent to one of the power rails.

Several embodiments of the circuit according to the invention are now described with more details.

Fig.2 illustrates one pixel of an array operating in continuous mode (i.e. without reset option) in case the detector anode is connected at the pixel amplifier input. A plurality of such pixels arranged in horizontal and vertical dimensions is normally taken to form a linear or focal plane pixel array. As illustrated in Fig.2, the photocurrent generated by the illumination of the photodiode 1, flows to the amplifier 2 input node 4 where it causes the input voltage to slightly rise. Because of the amplifier gain this results in an amplified drop of the output node 5 voltage of amplifier 2. The amplifier 2 is typically an inverting amplifier. The amplifier 2 is an operational transconductance amplifier (OTA), i.e. an amplifier that transforms an input voltage into an output current. The output voltage drop caused by the output current is applied at the source of the NMOS transistor 3 and causes the transistor to start conducting before the amplifier output reaches saturation if a suitable voltage bias VLOG is applied at its gate. The input node 4 is thus pulled low until no current flows anymore to the amplifier input and stabilizes. Note that in Fig.2 Vₛₛ and V_{dd} denote the negative and positive power supply voltages, respectively. Because of the logarithmic characteristic of the drain-source voltage as a function of the drain-source current of the NMOS transistor 3, the amplifier output will stabilize at a voltage value that approximately drops by about 60mV (at close to room temperatures) when the photocurrent is multiplied by 10, thus one decade. Thus for a range of input currents of 6 decades the output voltage is expected to change in a range of about 360mV only. The amplifier input voltage on the other hand will only increase by about 360mV divided by the amplifier gain. As long as the detector photocurrent is lower than say 1/10 or less of the amplifier bias current, one can expect the input voltage to change only less than a few mV. The detector reverse bias voltage can so be minimized without risk to enter in forward bias mode where it loses efficiency. The photocurrent flows to the amplifier output via the transistor, so the amplifier must be able to pull that current to ground (in this particular case) in order for the circuit to operate correctly. Thus the amplifier bias current must be at least higher than the incoming photocurrent to avoid the amplifier to saturate.

An important benefit of exploiting this logarithmic response and its resulting limited amplifier output voltage swing is that the so called analog supply voltage can be significantly reduced, resulting in less power consumption and reduced operating temperature of the device itself resulting in a lower photodiode leakage current. This aspect is of primary importance because it allows operation in worse ambient conditions and/or allows simpler camera designs possibly without or with reduced artificial cooling. Furthermore it allows usage of standard digital CMOS technologies with limited supply voltage capability.

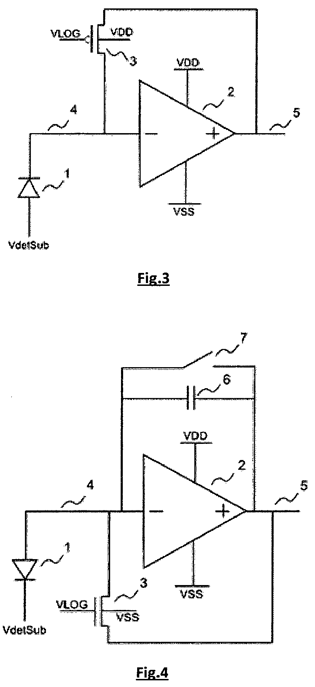

Fig.3 illustrates one pixel operating in continuous mode without reset in case the cathode of the detector is connected at the pixel amplifier input. As already mentioned the transistor then is of the PMOS type. A plurality of such pixels arranged in horizontal and vertical dimension is normally taken to form a so called linear or focal plane pixel array. The operation of this circuit is similar to that of Fig.2, only the polarities are interchanged.

In a preferred embodiment the amplifier 2 is a capacitive transimpedance amplifier (CTIA).

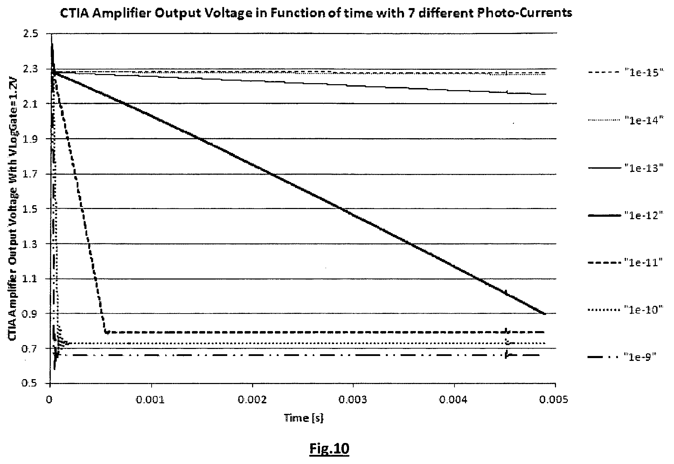

Fig.4 illustrates one pixel of an array operating in CTIA mode combined with an extended useful logarithmic range in case the anode of the detector 1 is connected to the pixel amplifier input. The usual CTIA range applies for small photocurrents in a linear range in function of the integration time up to a certain integration time value where the current taken by transistor 3 becomes larger than the current flowing into the CTIA integration capacitor.
In the embodiment of Fig.4 the amplifier is a Capacitive Trans-Impedance Amplifier (CTIA) with a capacitive feedback 6. Further a reset switch 7 is provided. The reset switch is usually also implemented with a MOS transistor. In this case the voltage biases are so adjusted that the MOS transistor 3 is not yet conducting after the CTIA reset has been released. Input current from the detector diode 1 flowing to the input of amplifier 2 tends to lower the output voltage, which in turn causes the current to flow into the feedback capacitor 6 until output node 5 reaches a value low enough to cause transistor 3 to start conducting. At that point, transistor 3 will settle the output node 5 voltage at a value depending on the input current value but compressed at a 60mV/input current decade format. This means that if the CTIA is set to integrate during a limited time, for example as 5ms defined by the output sampling time, one has two different output voltage zones. The lowest detector input currents are part of the normal CTIA linear zone, while the highest detector input currents are compressed at the 60mV/input current decade format before the end of integration time. See also Fig.10 for typical node 5 Voltage with different photocurrents and an integration capacitor of 3fF.

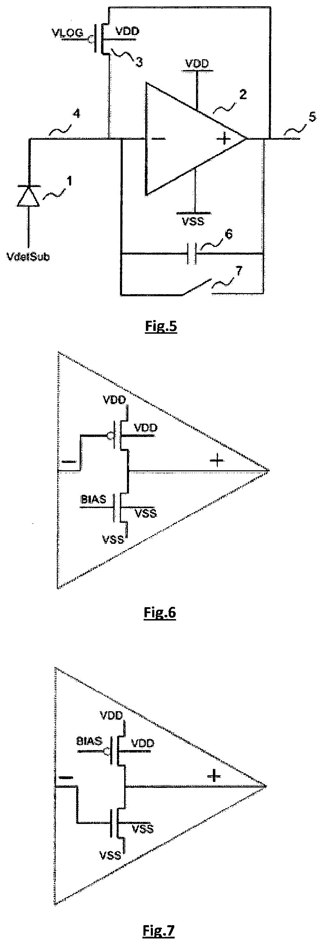

Fig. 5 illustrates the counterpart of Fig.3. A pixel operates in extended range CTIA mode in case the detector's cathode is connected at the pixel amplifier input. The operation of this circuit is similar to that of Fig.4, only the polarities are interchanged.

The reset switch 7 function shown in Fig.4 and Fig.5 can be replaced by pulsing the VLOG gate voltage to the supply rail in a direction forcing the MOS transistor 3 to become more conductive. This may be advantageous in cases where pixel size is critical.

Fig. 6 and 7 illustrate two examples of single-ended implementations of the pixel amplifier. In the shown examples the amplifiers are transconductance amplifiers.

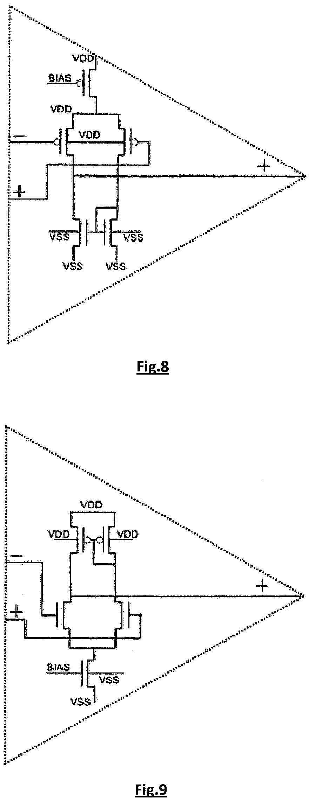

Fig 8 and 9 illustrate two possible differential implementations of the pixel amplifier. Also here transconductance amplifiers are used, as is commonly done in this kind of applications.

In practice the invention allows a given imager design to be used in three different modes by only adjusting bias voltages VLOG and drive signals to particular values:
- variable integration time CTIA in non-saturated linear mode with correlated double sampling (CDS) for highest sensitivity and lowest noise capture of possibly moving objects in limited contrast scenes.
- very long integration time (cooled for infrared detectors) dynamic linear CTIA combined with logarithmic compression range extension mode for widest dynamic range capture of very low light scenes combined with highly illuminated zones.
- static purely logarithmic compression continuous TIA mode (without reset) for wide dynamic range highly contrasted scenes.

In one aspect the invention also relates to a method for calibrating the detection circuit when used in the combined linear CTIA and logarithmic extension mode. As the calibration is influenced by the temperature this parameter needs to be taken into account. A suitable single and longest possible integration time is chosen particularly to fit the frame rate for performing the calibration and following operation procedure, for example 5 milliseconds. This integration time will be applied throughout the calibration and later operation. A practical transistor gate voltage is selected, i.e. at a level sufficiently high to avoid amplifier saturation. Then an iterative procedure is followed, wherein step by step the level of illumination applied to the photodiode is increased. This is repeated until saturation of the amplifier output or, in the practical case of an array of detector circuits (pixels), saturation of all amplifier outputs of the array is reached. This occurs when all outputs change less than -100mV for a 10x increase in illumination. Then the level of illumination is reduced again in small steps to, for example, 70% of the previous illumination level. Hereby the amplifier output is modified according to a logarithmic function, each time with an amount of e.g. about +10mV. Reducing the illumination level is repeated until an output variation is observed which is substantially higher (for example +100mV) than the substantially constant amount of about 10mV observed previously. The output values of those pixels are saved, so defining the transition value between linear and logarithmic operating range for later data manipulations. Once the detection circuit(s) has/have so been calibrated the detection circuit(s) is/are preferably operated at illumination ranges causing photocurrents values lower than about 1/10 of the chosen amplifier bias current.

Fig.10 provides some simulation results, showing the evolution of the CTIA amplifier output voltage over time when at the gate 1.2V is applied. Results are given for a number of photocurrent values. The figure shows that photocurrent values of 10⁻¹² A and higher clearly fall within the logarithmic compression range, while smaller currents are in the linear zone of the characteristic. Note that an integration time of 5 ms was taken to obtain the shown curves. Reduction of the integration time is not necessary to obtain information for higher levels of photocurrents.

While the invention has been illustrated and described in detail in the drawings and foregoing description, such illustration and description are to be considered illustrative or exemplary and not restrictive. The foregoing description details certain embodiments of the invention. It will be appreciated, however, that no matter how detailed the foregoing appears in text, the invention may be practiced in many ways. The invention is not limited to the disclosed embodiments.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. A single processor or other unit may fulfil the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

## Claims

1. Method for operating a detection circuit for detecting photocurrent, said detection circuit comprising a photodiode (1), a pixel amplifier (2) and a MOS transistor (3) having a gate, a source and a drain, said photodiode being connected to an input of a pixel amplifier (2) and said MOS transistor being connected between said input of said pixel amplifier and an output of said pixel amplifier, the method comprising the steps of
- illuminating said photodiode (1), yielding a photocurrent,
- applying to said pixel amplifier (2) an input voltage derived from said photocurrent,
- applying a current output by said pixel amplifier to said MOS transistor (3) whereby said output current forms a current between said drain and source of said MOS transistor, said MOS transistor being supplied at said gate with a gate voltage (VLOG), until said current between said drain and source substantially equals said photocurrent,
- exploiting a logarithmic portion of a gate-to-source voltage characteristic as a function of said current between said drain and source of said MOS transistor to obtain at the pixel amplifier output a voltage being a logarithmic function of said photocurrent.

2. Method for operating a detection circuit as in claim 1, wherein said MOS transistor is a NMOS transistor.

3. Method for operating a detection circuit as in claim 1, wherein said MOS transistor is a PMOS transistor.

4. Method for operating a detection circuit as in any of claims 1 to 3, wherein said pixel amplifier is a capacitive transimpedance amplifier.

5. Method for operating a detection circuit as in any of the previous claims, wherein said detection circuit comprises a reset switch (7).

6. Method for operating a detection circuit as in claim 5, wherein said reset switch is implemented with a further MOS transistor.

7. Method for operating a detection circuit as in any of the previous claims, comprising a step of pulsing said gate voltage (VLOG) to a supply rail so that a reset function is achieved.

8. Method for operating a detection circuit as in any of the previous claims, wherein said logarithmic portion of said gate-to-source voltage characteristic as a function of said current between said drain and source has a slope of about 60mV/photocurrent decade at room temperature.

9. Method for calibrating a detection circuit for detecting photocurrent, said detection circuit comprising a photodiode (1), a pixel amplifier (2) and a MOS transistor (3) having a gate, a source and a drain, said photodiode being connected to an input of a pixel amplifier (2) and said MOS transistor being connected between said input of said pixel amplifier and an output of said pixel amplifier, the method comprising the steps of
- selecting a transistor gate voltage (VLOG) level whereby saturation of the output of said pixel amplifier is avoided,
- increasing the level of illumination applied to said photodiode until saturation of the output of said pixel amplifier is reached,
- reducing gradually the level of illumination with a given step, thereby modifying said output of said amplifier, according to a logarithmic characteristic of a gate-to-source voltage as a function of a drain-source current of said MOS transistor, with a substantially constant amount until an output variation is observed substantially higher than said substantially constant amount, whereby levels of illumination corresponding to a modification of said output with said substantially constant amount determine a logarithmic range.

10. Detection circuit for detecting photocurrent comprising a photodiode (1), a pixel amplifier (2) and a MOS transistor (3) having a gate, a source and a drain, said photodiode being connected to an input of a pixel amplifier (2) and the drain and source of said MOS transistor being connected between said input of said pixel amplifier and an output of said pixel amplifier, and means for providing a gate voltage for said transistor, whereby said detection circuit is calibrated with the method for calibrating as in claim 9.

11. Detection circuit for detecting photocurrent as in claim 10, having a differential implementation.

12. Array of pixels comprising a plurality of detection circuits as in claim 10 or 11.

## Patentansprüche

1. Verfahren zum Betreiben eines Erkennungskreises zur Erkennung eines Fotostroms, wobei der besagte Erkennungskreis eine Fotodiode (1), einen Pixelverstärker (2) und einen MOS-Transistor (3) mit einer Steuerelektrode, einer Quelle und einem Abfluss umfasst, wobei die besagte Fotodiode an einen Eingang eines Pixelverstärkers (2) angeschlossen wird und der besagte MOS Transistor zwischen dem besagten Eingang des besagten Pixelverstärkers und einem Ausgang des besagten Pixelverstärkers angeschlossen wird, wobei das Verfahren die folgenden Schritte umfasst
- Beleuchten der besagten Fotodiode (1), zum Hervorbringen eines Fotostroms,
- Anlegen einer vom besagten Fotostrom abgeleiteten Eingangsspannung auf den besagten Pixelverstärker (2),
- Anlegen eines aus dem besagten Pixelverstärker ausgegebenen Stroms auf den besagten MOS Transistor (3), wobei der besagte Ausgangsstrom einen Strom zwischen dem besagten Abfluss und der Quelle des besagten MOS Transistors bildet, wobei der besagte MOS Transistor an der besagten Steuerelektrode mit einer Steuerelektrodenspannung (VLOG) versorgt wird, bis der besagte Strom zwischen dem besagten Abfluss und der Quelle im Wesentlichen dem besagten Fotostrom entspricht,
- Verwerten eines logarithmischen Teils eines Spannungsmerkmals zwischen Steuerelektrode und Quelle je nach dem besagten Strom zwischen dem besagten Abfluss und der Quelle des besagten MOS Transistors zum Erhalt einer Spannung am Pixelverstärker-Ausgang, die eine Logarithmusfunktion des besagten Fotostroms ist.

2. Verfahren zum Betreiben eines Erkennungskreises nach Anspruch 1, wobei der besagte MOS Transistor ein NMOS Transistor ist.

3. Verfahren zum Betreiben eines Erkennungskreises nach Anspruch 1, wobei der besagte MOS Transistor ein PMOS Transistor ist.

4. Verfahren zum Betreiben eines Erkennungskreises nach irgendeinem der Ansprüche 1 bis 3, wobei der besagte Pixelverstärker ein kapazitiver Transimpedanzverstärker ist.

5. Verfahren zum Betreiben eines Erkennungskreises nach irgendeinem der vorherigen Ansprüche, wobei der besagte Erkennungskreis einen Rückstellschalter (7) umfasst.

6. Verfahren zum Betreiben eines Erkennungskreises nach Anspruch 5, wobei der besagte Rückstellschalter mit einem weiteren MOS Transistor ausgeführt ist.

7. Verfahren zum Betreiben eines Erkennungskreises nach irgendeinem der vorherigen Ansprüche, einen Schritt zum Pulsen der besagten Steuerelektrodenspannung (VLOG) auf eine Stromschiene umfassend, sodass eine Rückstellfunktion erreicht wird.

8. Verfahren zum Betreiben eines Erkennungskreises nach irgendeinem der vorherigen Ansprüche, wobei der besagte logarithmische Teil des besagten Spannungsmerkmals zwischen Steuerelektrode und Quelle je nach dem besagten Strom zwischen dem besagten Abfluss und der Quelle eine Steigung von etwa 60 mV/Fotostrom-Dekade bei Raumtemperatur aufweist.

9. Verfahren zum Kalibrieren eines Erkennungskreises zur Erkennung eines Fotostroms, wobei der besagte Erkennungskreis eine Fotodiode (1), einen Pixelverstärker (2) und einen MOS Transistor (3) mit einer Steuerelektrode, einer Quelle und einem Abfluss umfasst, wobei die besagte Fotodiode an einen Eingang eines Pixelverstärkers (2) angeschlossen wird und der besagte MOS Transistor zwischen dem besagten Eingang des besagten Pixelverstärkers und einem Ausgang des besagten Pixelverstärkers angeschlossen wird, wobei das Verfahren die folgenden Schritte umfasst
- Auswählen eines Transistor-Steuerelektrodenspannungsniveaus (VLOG) wobei die Saturation des Ausgangs des besagten Pixelverstärkers vermieden wird,
- Erhöhen des Beleuchtungsniveaus, das auf die besagte Fotodiode angewandt wird, bis die Saturation des Ausgangs des Pixelverstärkers erreicht wird,
- Graduelle Verringerung des Beleuchtungsniveaus in einem gegebenen Schritt, und somit die Änderung des besagten Ausgangs des besagten Verstärkers entsprechend eines logarithmischen Merkmals einer Spannung zwischen Steuerelektrode und Quelle je nach Strom zwischen Abfluss und Quelle am besagten MOS Transistor mit einem im Wesentlichen konstanten Betrag, bis eine Ausgangsvariation beobachtet wird, die im Wesentlichen höher ist, als der besagte im Wesentlichen konstante Betrag, wobei die Beleuchtungsniveaus entsprechend einer Änderung des besagten Ausgangs mit dem besagten im Wesentlichen konstanten Betrag einen logarithmischen Bereich bestimmen.

10. Erkennungskreis zur Erkennung eines Fotostroms, eine Fotodiode (1), einen Pixelverstärker (2) und einen MOS Transistor (3) mit einer Steuerelektrode, einer Quelle und einem Abfluss umfassend, wobei die besagte Fotodiode an einen Eingang eines Pixelverstärkers (2) angeschlossen wird und Abfluss und Quelle des besagten MOS Transistors zwischen dem besagten Eingang des besagten Pixelverstärkers und einem Ausgang des besagten Pixelverstärkers angeschlossen werden, und Mittel zum Bereitstellen einer Steuerelektrodenspannung für den besagten Transistor, wobei der besagte Erkennungskreis entsprechend dem Verfahren zum Kalibrieren nach Anspruch 9 kalibriert wird.

11. Erkennungskreis zur Erkennung eines Fotostroms nach Anspruch 10, mit einer unterschiedlichen Umsetzung.

12. Anordnung von Pixeln, eine Vielzahl von Erkennungskreisen nach Anspruch 10 oder 11 umfassend.

## Revendications

1. Un procédé d'actionnement d'un circuit de détection destiné à la détection d'un photocourant, ledit circuit de détection comprenant une photodiode (1), un amplificateur de pixels (2) et un transistor MOS (3) possédant une grille, une source et un drain, ladite photodiode étant raccordée à une entrée d'un amplificateur de pixels (2) et ledit transistor MOS étant raccordé entre ladite entrée dudit amplificateur de pixels et une sortie dudit amplificateur de pixels, le procédé comprenant les opérations suivantes :
- l'éclairage de ladite photodiode (1), de façon à produire un photocourant,
- l'application audit amplificateur de pixels (2) d'une tension d'entrée dérivée dudit photocourant,
- l'application d'un courant produit en sortie par ledit amplificateur de pixels audit transistor MOS (3), grâce à quoi ledit courant de sortie forme un courant entre lesdits drain et source dudit transistor MOS, ledit transistor MOS étant fourni à ladite grille avec une tension de grille (VLOG), jusqu'à ce que ledit courant entre lesdits drain et source soit sensiblement égal audit photocourant,
- l'exploitation d'une partie logarithmique d'une caractéristique de tension grille à source sous la forme d'une fonction dudit courant entre lesdits drain et source dudit transistor MOS de façon à obtenir au niveau de la sortie de l'amplificateur de pixels une tension qui est une fonction logarithmique dudit photocourant.

2. Le procédé d'actionnement d'un circuit de détection selon la Revendication 1, où ledit transistor MOS est un transistor NMOS.

3. Le procédé d'actionnement d'un circuit de détection selon la Revendication 1, où ledit transistor MOS est un transistor PMOS.

4. Le procédé d'actionnement d'un circuit de détection selon l'une quelconque des Revendications 1 à 3, où ledit amplificateur de pixels est un amplificateur à transimpédance capacitive.

5. Le procédé d'actionnement d'un circuit de détection selon l'une quelconque des Revendications précédentes, où ledit circuit de détection comprend un commutateur de réinitialisation (7).

6. Le procédé d'actionnement d'un circuit de détection selon la Revendication 5, où ledit commutateur de réinitialisation est mis en oeuvre avec un autre transistor MOS.

7. Le procédé d'actionnement d'un circuit de détection selon l'une quelconque des Revendications précédentes, comprenant une opération d'envoi par impulsion de ladite tension de grille (VLOG) à un rail d'alimentation de sorte qu'une fonction de réinitialisation soit mise en oeuvre.

8. Le procédé d'actionnement d'un circuit de détection selon l'une quelconque des Revendications précédentes, où ladite partie logarithmique de ladite caractéristique de tension grille à source sous la forme d'une fonction dudit courant entre lesdits drain et source possède une pente d'environ 60mV/photocourant par décade à température ambiante.

9. Un procédé de calibrage d'un circuit de détection destiné à la détection d'un photocourant, ledit circuit de détection comprenant une photodiode (1), un amplificateur de pixels (2) et un transistor MOS (3) possédant une grille, une source et un drain, ladite photodiode étant raccordée à une entrée d'un amplificateur de pixels (2) et ledit transistor MOS étant raccordé entre ladite entrée dudit amplificateur de pixels et une sortie dudit amplificateur de pixels, le procédé comprenant les opérations suivantes :
- la sélection d'un niveau de tension de grille de transistor (VLOG), grâce à quoi une saturation de la sortie dudit amplificateur de pixels est évitée,
- l'augmentation du niveau d'éclairage appliqué à ladite photodiode jusqu'à ce qu'une saturation de la sortie dudit amplificateur de pixels soit atteinte,
- la réduction graduelle du niveau d'éclairage d'un pas donné, modifiant ainsi ladite sortie dudit amplificateur, selon une caractéristique logarithmique d'une tension grille à source sous la forme d'une fonction d'un courant source-drain dudit transistor MOS, avec une quantité sensiblement constante jusqu'à ce qu'une variation en sortie soit observée sensiblement supérieure à ladite quantité sensiblement constante, grâce à quoi des niveaux d'éclairage correspondant à une modification de ladite sortie avec ladite quantité sensiblement constante déterminent une plage logarithmique.

10. Un circuit de détection destiné à la détection d'un photocourant comprenant une photodiode (1), un amplificateur de pixels (2) et un transistor MOS (3) possédant une grille, une source et un drain, ladite photodiode étant raccordée à une entrée d'un amplificateur de pixels (2), et les drain et source dudit transistor MOS étant raccordés entre ladite entrée dudit amplificateur de pixels et une sortie dudit amplificateur de pixels, et un moyen de fourniture d'une tension de grille pour ledit transistor, grâce à quoi ledit circuit de détection est calibré avec le procédé de calibrage selon la Revendication 9.

11. Un circuit de détection destiné à la détection d'un photocourant selon la Revendication 10, possédant une mise en oeuvre différentielle.

12. Une matrice de pixels comprenant une pluralité de circuits de détection selon la Revendication 10 ou 11.
